# EUROPEAN PATENT SPECIFICATION

(11) **EP 2 713 412 B1**
(45) Date of publication and mention of the grant of the patent: **09.11.2016**
(21) Application number: 13186514.9
(22) Date of filing: 27.09.2013
(51) Int. Cl.: H01L 35/30, H01L 35/32

(54) **Improved thermoelectric generator.**
Verbesserter thermoelektrischer Generator
Générateur thermoélectrique amélioré

(30) Priority: 27.09.2012 IT VI20120243
(43) Date of publication of application: 02.04.2014
(73) Proprietor: Veil Energy S.R.L., 39100 Bolzano (IT)
(72) Inventor: BENETTI, Marianna, 36040 GRUMOLO DELLE ABBADESSE (VI) (IT)
(74) Representative: Bonini, Ercole

(56) References cited:
- FR-A1- 2 463 372
- FR-A1- 2 965 402
- US-A- 3 196 620

## Description

The invention concerns a thermoelectric generator of improved type that uses a plurality of Seebeck effect cells to efficiently convert heat energy into electric energy.

As is known, Seebeck effect cells are thermoelectric converters capable of producing electric energy when one of their surfaces is heated and the opposite surface is cooled.

The electric current that is produced can be introduced in an electric circuit supplying power to any electric device.

For the sake of simplicity, in the description below the term "thermoelectric converter" or simply the term "cell" will be used to indicate a Seebeck effect cell.

On the market it is possible to find devices and systems that use said thermoelectric converters in order to produce electric energy by exploiting the difference in temperature existing between the gases or the exhaust fumes and any other cold fluid.

In particular, thermoelectric generators are known that are installed on vehicles propelled by endothermic motors or by turbines that use thermoelectric converters to produce electric energy that is used on the same vehicle, exploiting the heat difference existing between the hot exhaust gases coming from the motor and the coolant, which is cold, coming from the motor's cooling circuit.

For example, the patent document EP 2 337 101 is known, which describes a thermoelectric generator substantially comprising a first tubular body whose external surface has a plurality of thermoelectric converters applied thereon and a second tubular body, internally coaxial with the first tubular body, which together define an annular tubular duct.

The annular tubular duct and the external tubular surface are crossed and touched by fluids having different temperatures, so that each thermoelectric converter is subjected to a difference in temperature and generates electric energy.

The thermoelectric generator just described above has the limitation that it uses shaped thermoelectric converters that must be produced specifically for this purpose.

Furthermore, the coaxial configuration poses some difficulties when it is necessary to perform maintenance operations and/or repairs.

Another patent document, number KR20110077486, describes a thermoelectric generator in which the surfaces of the thermoelectric converters are associated on one side with a heat exchanger and on the other side with a heat dissipator.

The generator is complicated to construct and offers low efficiency, as the heat exchange between the thermoelectric converters and the hot and cold fluids does not take place directly but through the interposition of the exchanger and the dissipator.

A further patent document, number US 2011/0239635, describes a thermoelectric generator comprising a duct with a hot fluid flowing therein and having the thermoelectric converters applied to its external surface so that their contact surfaces are heated.

The opposing surfaces of the thermoelectric converters, instead, are cooled by a heat dissipator with a cold fluid circulating inside it.

The generator is provided with a valve that makes it possible to reverse the direction of the flow of the cold fluid from a direction corresponding to the flow direction of the hot fluid to a contrary direction with respect to the latter, so as to define different operating conditions for the generator.

The limitations posed by said generator consist in its construction complexity and in the fact that it is difficult to intervene to carry out maintenance operations.

The patent documents US 2012/0011836 and US 2011/0012106 are also known, both of which describe a thermoelectric generator comprising a plurality of overlapping undulated disks that house the thermoelectric converters and define a plurality of channels for the passage of the hotter fluid. Flat cooling disks are interposed between the undulated disks.

Even the thermoelectric generators described in the above mentioned patent documents pose acknowledged drawbacks that lie in their construction complexity and their high production costs, mainly due to the special shape of the disks and the thermoelectric converters, and in the difficulties encountered when making repairs and replacements, mainly due to their configuration that requires that all the disks are stacked on one another.

Furthermore, all the thermoelectric generators described in the above mentioned patent documents are based on design concepts that make them particularly suited to be used on motor vehicles, and this represents a recognized limitation to their use in other sectors and other types of systems. The patent document US 3,196,620 is known, which describes a thermoelectric heat pump using thermoelectric converters that are included between tubular elements, in which a first heat exchange fluid circulates, and fins that are in contact with a second heat exchange fluid.

Each tubular element is constituted by tubular sleeves in copper, coaxially coupled one after the other and mutually separated axially through nonconductive rings, and each thermoelectric converter has one face welded to a corresponding sleeve, while the opposite face is welded to copper strip that in turn is welded to the fins through the interposition of an electrically insulating film.

A first drawback is represented by the construction complexity, due to the large number of components to be assembled and to the need to weld all the thermoelectric converters to the tubular elements and to the fins applying all the insulating elements.

Another drawback derives from the fact that the thermoelectric converters, needing to be properly shaped in order to be able to be welded to the tubular elements, are thus special elements that are difficult to find on the market. Another drawback derives from the fact that it is difficult to guarantee the seal between the sleeves making up the tubular elements over time.

Another drawback is constituted by the fact that the heat exchange between the fluids and both the surfaces of the thermoelectric converters takes place indirectly by conduction through the surfaces of the ducts in which said fluids circulate, and this negatively affects the efficiency of the heat exchange with respect to the efficiency that could be obtained if one or both of the surfaces of the converters were in direct contact with the respective heat exchange fluids. Another inconvenience is due to the fact that the heat exchange that is obtained by means of the fins is a discontinuous heat exchange, which is of further detriment to the efficiency of the heat exchange.

Another inconvenience derives from the fact that the thermoelectric converters and the heat exchange surfaces are welded to each other and thus the configuration of the heat pump is not easy to modify, for example through the addition of elements intended to increase its power.

Another drawback derives from the fact that the construction complexity of the exchanger makes disassembly and maintenance operations complicated to carry out.

The patent document FR 2 463 372 is also known, which describes a thermoelectric device comprising a plurality of thermoelectric elements that, exchanging heat with fluids at different temperatures, generate electric current as a consequence of the Seebeck effect.

In particular, each thermoelectric element has one of its faces fixed to a thermally conductive supporting element, wherein a plurality of said supporting elements are aligned and spaced from one another and are applied to a thermally conductive containment wall.

The whole is contained in an external casing that, together with the containment wall, defines a channel in which a first one of the heat exchange fluids flow and inside which there is a plurality of heat exchange fins that are welded to the containment wall, on the opposite side of the supporting elements of the thermoelectric elements.

On the face of each thermoelectric element, opposing the face fixed to the thermally conductive supporting element, there is a thermally conductive projection that is welded thereto and is fixed to a shaped conductive element supporting a coil-shaped tubular element through which the second heat exchange fluid flows.

Therefore, the device described has a channel provided with heat exchange fins, in which the first heat exchange fluid circulates, and with a coil-shaped pipe, in which the second heat exchange fluid circulates. The thermoelectric elements have an active surface in contact with the fins and the other active surface in contact with the coil-shaped pipe.

The construction complexity of the device, due to the large number of components to be assembled, even through welding operations, leads to the drawback that its manufacture and maintenance are expensive.

A further drawback is constituted by the fact that the heat exchange between the fluids and both the surfaces of the thermoelectric converters takes place by conduction through the surfaces in which the heat exchange fluids circulate and this negatively affects the heat exchange efficiency of the device compared to the efficiency that could be obtained if one or both of the surfaces of the converters were in direct contact with the respective heat exchange fluids.

A further drawback is due to the presence of the fins inside the channel in which the heat exchange fluid circulates, since they produce a heat exchange of a discontinuous type and cause flow resistance, which further contributes to worsen the efficiency of the device.

The patent document FR 2 965 402 is also known, which describes a thermoelectric device suited to generate electric current and comprising a first circuit for the circulation of a first fluid, a second circuit for the circulation of a second fluid and thermoelectric elements in contact with said circuits to generate an electric current in the presence of a temperature gradient between the fluids.

Both of the circuits are constituted by tubular elements configured as a coil that intersect according to planes that are orthogonal to each other. The tubular elements, which for example form the first one of said circuits, have a substantially quadrilateral cross section delimited by at least two opposing plane surfaces.

The thermoelectric elements are then prepared with one of the active faces directly fixed to the plane surfaces of the tubular elements that form the first circuit, while the other active face is fixed to thermally conductive fins that in turn are mechanically fixed to the tubular elements that form the second circuit. A drawback posed by the thermoelectric devices manufactured according to the patent document mentioned above is represented by their construction complexity, which is due to the large number of components to be assembled. Furthermore, there are practical difficulties in connecting, mechanically and circumferentially outside the tubular elements of the first circuit, the thermally conductive fins to which the thermoelectric elements are in turn fixed. This construction complexity is further enhanced by the fact that said mechanical connection must guarantee not only heat conduction between the fluid circulating in the tubular elements and the thermoelectric elements, but also electric insulation between the tubular elements and the thermoelectric elements themselves. Therefore, each connection must also include interposed electrically insulating elements.

Another drawback is constituted by the fact that the heat exchange between the fluids and both of the surfaces of the thermoelectric converters takes place by conduction through the surfaces within which the heat exchange fluids circulate and with which the thermoelectric elements are into contact. This, in fact, negatively affects the thermal efficiency of the device compared to the efficiency that could be obtained if one or both of the surfaces of the thermoelectric elements were in direct contact with the respective heat exchange fluids.

Another drawback is constituted by the fact that the circulation of at least one of the heat exchange fluids inside coil-shaped pipes takes place resulting in higher flow resistance and lower heat exchange efficiency compared to those that could be obtained if the circulation took place inside linear ducts preferably having plane surfaces facing each other.

The present invention intends to overcome all the drawbacks and limitations mentioned above.

In particular, it is a first object of the invention to provide a thermoelectric generator using thermoelectric converters (cells with Seebeck effect) that is simpler to construct than the known thermoelectric generators.

It is another object of the invention to provide a thermoelectric generator whose production costs are lower than those of known thermoelectric generators similar to it and having the same power.

It is a further object of the invention to provide a thermoelectric generator whose overall dimensions are smaller than those of known thermoelectric generators similar to it and having the same power.

It is another object of the invention to provide a thermoelectric generator that uses only and exclusively thermoelectric converters (cells with Seebeck effect) available on the market.

The objects mentioned above are achieved by the thermoelectric generator of the invention that is carried out according to the contents of the main claim, to which reference is made.

Other details of the invention are specified in the dependent claims.

The thermoelectric generator of the invention is made of metallic parts, properly shaping the elements that make it up by means of simple shearing and bending operations, and assembling the elements together by means of mechanical fixing operations, if necessary comprising also welding operations. Therefore, costly operations for chip removal performed with traditional machine tools or CNC machines are thus excluded or however limited to the minimum indispensable.

Advantageously, all the above makes the construction of the generator of the invention simpler and more economic compared to the generators described in the patent documents mentioned above.

Furthermore, the thermoelectric converters that are used to make the generator of the invention are, as already explained, of the type available on the market and are fixed to special flat laminar elements with reduced thickness, also obtained by shearing metal sheet and shaping it, if necessary. The thermoelectric converters available on the market are supplied provided with suitable electrical insulators and this facilitates the construction of the generator, since it is not necessary to apply the insulating elements during the assembly operations.

According to the embodiments of the invention that are illustrated here below, the generator comprises a plurality of flat laminar elements with reduced thickness that support the thermoelectric converters and a plurality of plane insulating panels, each one of which is arranged so that it faces and is parallel to a corresponding laminar element.

In this way, the laminar elements and the insulating panels are arranged in an array and together they define a plurality of ducts for the passage of the hot and cold fluid for the heat exchange with the thermoelectric converters.

In practice, the generator assumes a structure that consists of a plurality of wafer elements, each one of which is defined by a laminar element and by an insulating panel facing and spaced from each other.

The fluid passage ducts are thus defined inside each one of the wafer elements and between the wafer elements.

Advantageously, said construction form with laminar elements and insulating panels arranged in an array makes it possible to obtain considerable heat exchange between the thermoelectric converters and the fluids, and thus to obtain high electric power density.

It is thus possible to provide a generator that, given the same volume, generates more electric power than equivalent generators of known type. Furthermore, to advantage, this construction simplicity also facilitates disassembly and re-assembly operations when it is necessary to work on the generator to carry out maintenance operations and/or repairs.

Still advantageously, the construction criteria described above optimise the efficiency of the heat exchanges, as the fluids come directly into contact with the surfaces of the cells or with the laminar elements with reduced thickness that support them and this involves better efficiency of the generator of the invention compared to known generators equivalent to it.

Furthermore, the construction criteria described above make it also possible to provide a generator of the modular type, whose power can be increased by simply increasing the number of insulating panels and corresponding laminar elements arranged in an array.

To further advantage, the construction criteria described above make the generator of the invention more versatile than the known generators and make it particularly suited to be used especially in static systems of any type, where there are fluids at different temperatures.

Still advantageously, the cold fluid that circulates in the generator and that overheats during the energy production process can be usefully recovered at the outlet of the generator and re-used.

In this way, in static installations, for example biogas generation systems using the generator of the invention, the heat contained in the cold fluid flowing out of the generator can be usefully employed to heat the biomass in the anaerobic digester.

In other static installations, the heat contained in the cold fluid flowing out of the generator can be usefully employed to heat rooms.

Furthermore, the heat contained in the cold fluid flowing out of the generator can also be usefully employed to pre-heat the motor or other fluids within the system.

The objects and advantages described above will be highlighted in greater detail in the description of preferred but non-exclusive embodiments of the thermoelectric generator of the invention that are illustrated here below with reference to the attached drawings, wherein:
- Figure 1 shows an axonometric view of the generator that is the subject of the invention;
- Figure 2 shows the inside of the generator shown in Figure 1;
- Figure 3 shows a top view of the generator of Figure 2;

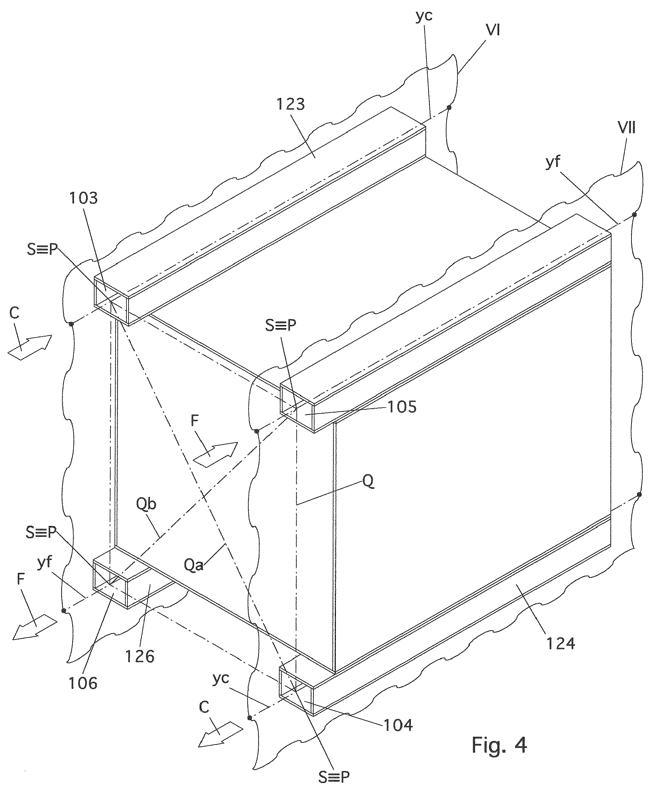

- Figure 4 shows an axonometric view of a construction variant of the generator of the invention;
- Figure 5 shows an exploded view of the generator of Figure 4;
- Figure 6 shows a sectional view of the generator of Figure 4 according to plane VI - VI;
- Figure 7 shows a sectional view of the generator of Figure 4 according to plane VII - VII.

The thermoelectric generator that is the subject of the invention is shown in different views in Figures from 1 to 3, where it is indicated as a whole by **1.**

It can be observed that it comprises a containment body, indicated as a whole by **2** and provided with walls **12a** that delimit a heat exchange chamber **12,** in which it is possible to identify a first inlet way **3** and a first outlet way **4** of a first heat exchange fluid **C** and a second inlet way **5** and a second outlet way **6** of a second heat exchange fluid **F.**

Said heat exchange fluids **C** and **F** have different temperatures.

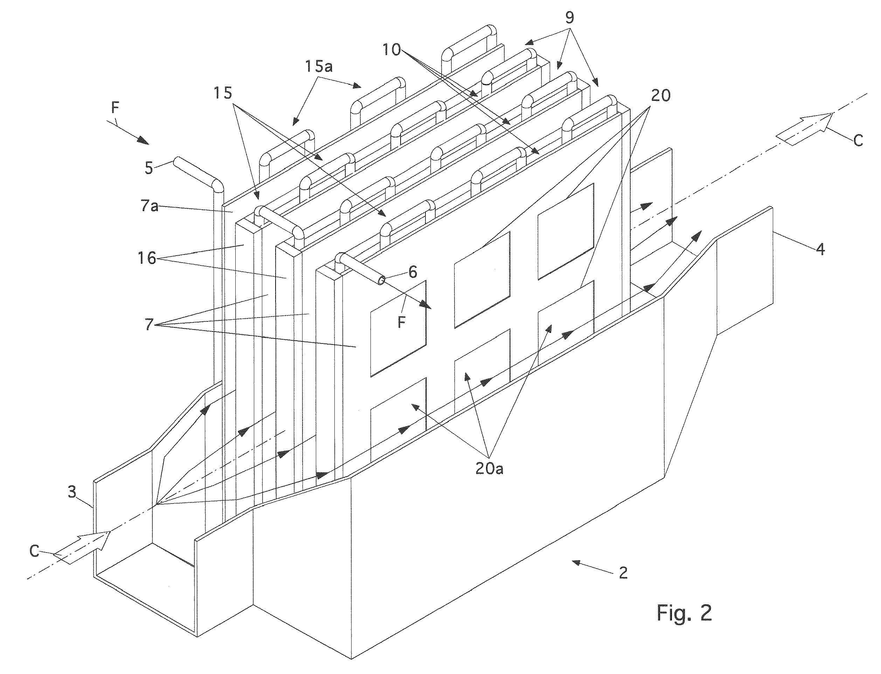

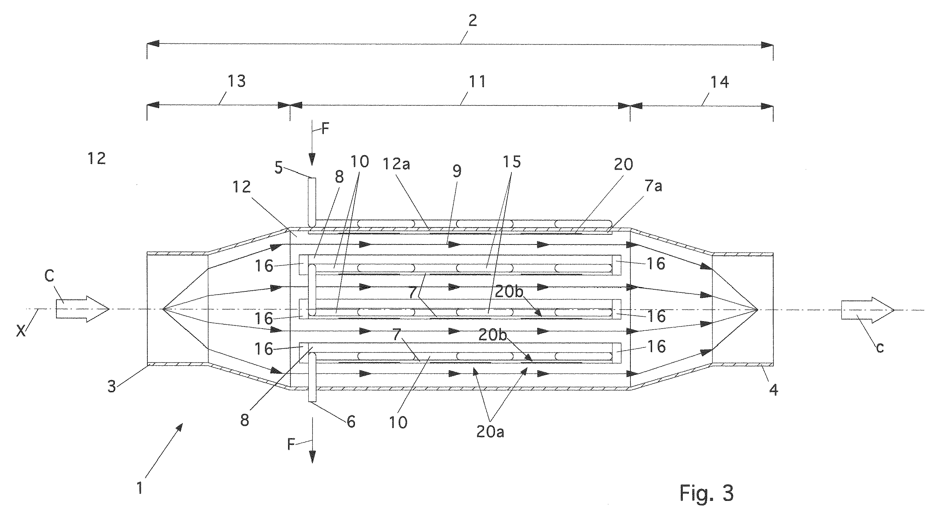

It should be noted that the heat exchange fluids **C** and **F** can indifferently be liquid or gaseous, and in general can be any of those substances that in physics are defined with the term "fluids". Inside the containment body **2,** as can be observed in particular in Figure 2 and in Figure 3, there are a plurality of thermoelectric converters **20,** each one of which has a first surface **20a** facing towards the first heat exchange fluid **C** and a second surface **20b,** opposite the first surface **20a,** facing towards the second heat exchange fluid **F.**

The thermoelectric converters **20** are constituted by cells with Seebeck effect. In the following description each cell with Seebeck effect will be referred to as "thermoelectric converter" or more simply as "cell".

According to the invention, the thermoelectric converters **20** are supported by spaced laminar elements **7** that face corresponding thermally insulating panels **8,** said laminar elements **7** and said thermally insulating panels **8** being housed inside the containment body **2,** where they define a plurality of first flow ducts **9** communicating with the first inlet ways **3** and outlet ways **4** for the circulation of the first heat exchange fluid **C** and a plurality of second flow ducts **10** communicating with the second inlet ways **5** and outlet ways **6** for the circulation of the second heat exchange fluid **F,** wherein each one of the first flow ducts **9** is arranged adjacent and parallel to a corresponding second flow duct **10,** and each one of the thermoelectric converters **20** has its first surface **20a** in direct contact with the first heat exchange fluid **C.**

Said laminar elements **7** and said thermally insulating panels **8,** as shown also in the view of Figure 3, are preferably but not necessarily flat and are arranged parallel to the direction defined by the longitudinal axis **X** of the first inlet ways **3** and outlet ways **4** of the containment body **2.**

In particular, it can be observed that the containment body **2** comprises: a central section **11** that delimits a heat exchange chamber **12** and in which the flat laminar elements **7** and the flat thermally insulating panels **8** are arranged, an inlet section **13** whose profile diverges towards the central section **11** in which there is the first inlet way **3** of the first heat exchange fluid **C,** and an outlet section **14** whose profile diverges from the central section **11,** in which there is the first outlet way **4** of the first heat exchange fluid **C.**

The inlet way **3** and the outlet way **4** are aligned with each other according to the above mentioned longitudinal axis **X** that develops along the inlet sections **13** and the outlet sections **14** and along the central section **11** parallel to the flat laminar elements **7** and the flat thermally insulating panels **8** and that defines the flow direction of the first heat exchange fluid **C.**

With particular reference to Figure 3, it is also possible to observe the presence of an auxiliary flat laminar element **7a** that is arranged inside the heat exchange chamber **12** in contact with the wall **12a** that delimits it.

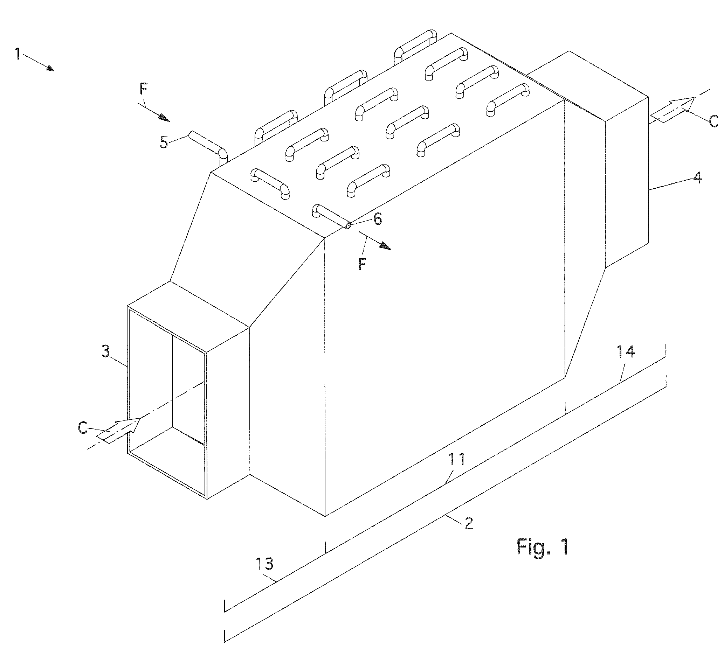

It can also be observed that inside the second flow ducts **10** the second heat exchange fluid **F** flows along a plurality of tubular coils **15,** visible in particular in the axonometric views of Figures 1 and 2, which are connected in series to one another and with the second inlet way **5** and outlet way **6.**

Each one of said tubular coils **15,** inside the corresponding second flow duct **10** in which it is housed, is placed in contact with the flat laminar element **7** and the flat thermally insulating panel **8.**

Finally, it is also possible to observe the presence of an auxiliary tubular coil **15a** that is arranged outside the heat exchange chamber **12** and is placed in contact with the wall **12a** that delimits the latter, at the level of the area of said wall **12a** where, internally, there is the auxiliary laminar element **7a.**

Finally, the second flow ducts **10** are provided with lateral closing edges **16** opposing each other. Furthermore, when the flat laminar elements **7** and the flat thermally insulating panels **8** that define said second flow ducts **10** are assembled together and enclosed within the heat exchange chamber **12,** the second flow ducts **10** are closed even along the upper and lower edges by the walls **12a** that delimit the heat exchange chamber **12.**

In this way, the generator assumes a wafer-like structure, in which each one of said wafer elements is defined by a flat laminar element **7** and by a flat thermally insulating panel **8** between which the second flow duct **10,** which is thus configured as an adiabatic chamber, is defined.

Furthermore, since each second flow duct **10** is tightly closed through the perimetric closing means comprising said lateral closing edges **16** and the side walls **12a** of the heat exchange chamber **12,** the pressure inside it can be maintained at a value lower than that of the atmospheric pressure.

This makes it possible to improve the heat exchange coefficient and increases the efficiency of the generator.

In practice, the first heat exchange fluid **C** that enters the heat exchange chamber **12** through the first inlet way **3** flows along each first flow duct **9** and exchanges heat with the first surfaces **20a** of the thermoelectric converters **20** before flowing out through the first outlet way **6** of the same heat exchange chamber **12.**

It is important to notice that the first heat exchange fluid **C** comes into contact with the first surfaces **20a** of the thermoelectric converters **20** thus producing, along each first flow duct **9,** a heat exchange through direct contact, whose exchange efficiency is thus certainly higher than the efficiency that could be obtained with the mentioned known generators, in which said heat exchange with the corresponding first surfaces of the thermoelectric converters takes place by conduction through the interposed exchange surfaces of the ducts or circuits in which said exchange fluid circulates.

It can also be observed that the passage cross section of the first flow duct **9** is free, since there are not the heat exchange fins that instead are present in the thermoelectric generators of the known art.

At the same time, the second heat exchange fluid **F** that enters through the second inlet way **5** flows inside each second flow duct **10** circulating along the coils **15, 15a** and thus exchanging heat with each second surface **20b** of the thermoelectric converters **20** before flowing out through the second outlet way **6**.

The flows of the fluids are represented by the arrows **C** and **F.**

During the circulation the thermoelectric converters **20** produce a difference in potential that is withdrawn through electric leads, not shown in the drawings, that are connected to a line transporting the electric current produced to any user.

In a variant embodiment of the invention, represented in Figures from 4 to 7, the thermoelectric generator, indicated as a whole by **100,** differs from the embodiment just described above in that the flat laminar elements **107** that support the thermoelectric converters **120** and the flat thermally insulating panels **108** are arranged so that they are orthogonal to the directions of the flows of the heat exchange fluids **C** and **F** that are defined by the longitudinal axes **Yc** and **Yf** through the inlet ways **103, 105** and the outlet ways **104, 106.** In particular, the containment body **102** defines the heat exchange chamber **112,** delimited by the side wall **111,** in which there are the flat laminar elements **107** and the flat thermally insulating panels **108** that delimit the first flow ducts **109** and the second flow ducts **110.**

First of all it should be observed that the inlet ways **103, 105** and the outlet ways **104, 106** are all positioned on the same side of the containment body and this facilitates installation, as the installer can operate working on one side only of the generator.

The flow ducts **109** and **110** are perimetrically closed by perimetric closing means that, as can be observed in the figures, are constituted by the side wall **111** that delimits the heat exchange chamber **112** inside the containment body **102.**

Even in this variant embodiment, the generator assumes a wafer-like structure, in which each one of said wafer elements is defined by a flat laminar element **107** and by a flat thermally insulating panel **108** between which the second flow duct **110** is defined, said second flow duct being thus configured as an adiabatic chamber.

The containment body **102** is associated with a first inlet channel **123** and a first outlet channel **124** provided with the respective first inlet way **103** and first outlet way **104** of the first heat exchange fluid **C** and a second inlet channel **125** and a second outlet channel **126** provided with the respective second inlet way **105** and second outlet way **106** of the second heat exchange fluid **F.**

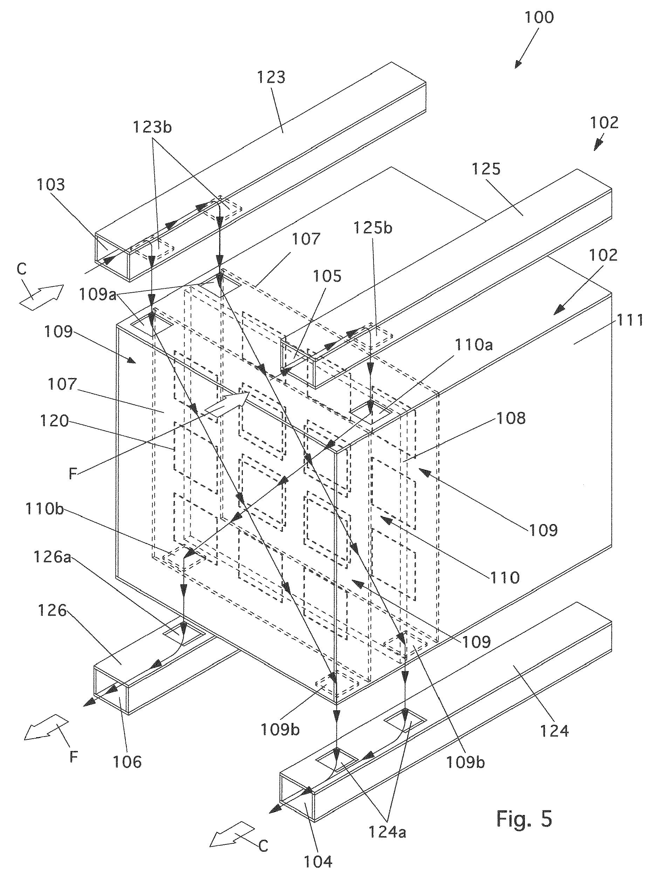

It can be observed in particular in Figures 5, 6 and 7 that the first inlet channel **123** is also provided with a plurality of first outlet mouths **123b,** each one of which communicates with a corresponding first inlet mouth **109a** created in the containment body **102** and communicating with a respective first flow duct **109,** while the first outlet channel **124** is provided with a plurality of first inlet mouths **124a,** each one of which communicates with a corresponding first outlet mouth **109b** created in the containment body **102** and communicating with the same first flow duct **109.**

The inlet and outlet mouths are represented in the drawings with square or rectangular cross section.

It must be understood that this embodiment is represented only by way of example, as the mouths can be made in any type of shape in addition to the polygonal shape.

In particular, for reasons related to fluid mechanics, the mouths will preferably have a circular, elliptic or oval shape, and their cross section will be sized so as to regulate the flow rates.

For this purpose, at the level of the mouths, if necessary, it will be possible to provide partialization means suited to regulate the flows, like for example diaphragms, gates or similar devices.

Each first outlet mouth **109b** is arranged in a remote position with respect to the position in which the first inlet mouth **109a** is arranged.

Analogously, it can be observed that the second inlet channel **125** is also provided with a plurality of second outlet mouths **125b,** each one of which communicates with a respective first inlet mouth **109a** created in the containment body **102** and communicating with a respective second flow duct **110,** while the second outlet channel **126** is provided with a plurality of second inlet mouths **126a,** each one of which communicates with a corresponding second outlet mouth **110b** created in the containment body **102** and communicating with the same second flow duct **110.**

Each second inlet mouth **110a** is arranged in a remote position with respect to the position in which the second outlet mouth **110b** is arranged.

Said inlet channels **123, 125** and outlet channels **124, 126** define the longitudinal axes **Yc** and **Yf,** respectively, which define the flow directions of the heat exchange fluids C and F along said channels that, as can be observed, are arranged orthogonally to the flow ducts **109, 110,** the flat laminar elements **107** and the flat thermally insulating panels **108.**

More particularly, it can be observed in Figure 5 that the inlet channels **123, 125** and outlet channels **124, 126** are tubular elements with cross section in any shape, positioned outside the containment body **102** and arranged according to the configuration of a quadrilateral **Q** in which each one of the corners **S** of the quadrilateral coincides with the point of intersection **P** of a corresponding longitudinal axis **Yc, Yf** of said channels.

Furthermore, as can be observed, the inlet and outlet channels **123, 124** of the first heat exchange fluid **C** are arranged at the ends of a first diagonal **Qa** of said quadrilateral **Q** and the inlet and outlet channels **125, 126** of the second heat exchange fluid **F** are arranged at the ends of a second diagonal **Qb** of the same quadrilateral, which intersects the first diagonal **Qa.**

Therefore, in each flow duct **109, 110** the respective inlet mouth **109a, 110a** and the corresponding outlet mouth **109b, 110b** are diagonally aligned with each other according to the direction defined by the diagonals **Qa** and **Qb,** respectively.

The diagonal arrangement of the inlet and outlet channel, respectively **123, 124** and **125, 126** improves the distribution of the flows inside the flow ducts and thus improves the efficiency of the heat exchange.

In practice, according to said variant embodiment, the heat exchange fluids **C** and **F** that flow in and out through the respective inlet and outlet channels flow at right angles to the flat laminar elements **107** and the flat thermally insulating panels **108** and run diagonally through each corresponding flow duct **109, 110** as indicated by the arrows, between each inlet mouth **109a, 110a** and the corresponding outlet mouth **109b, 110b.**

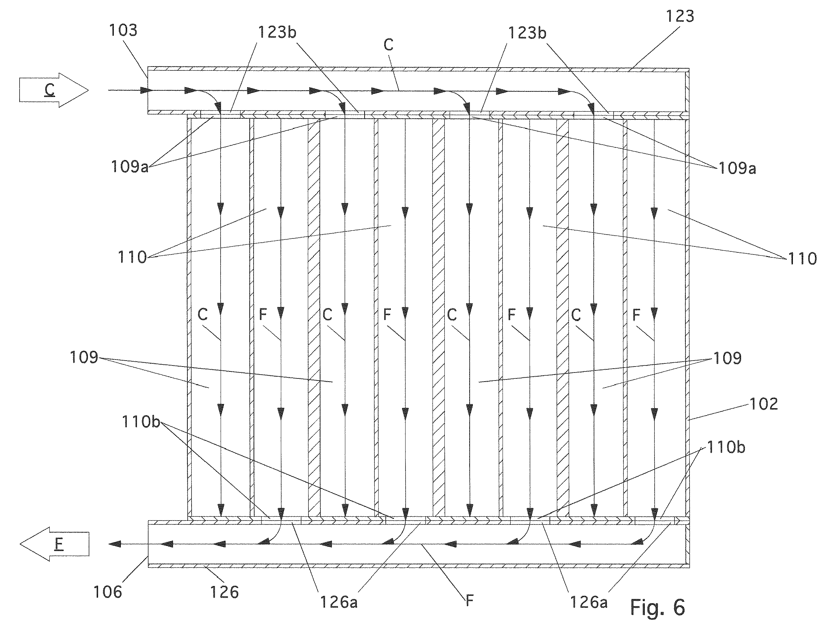

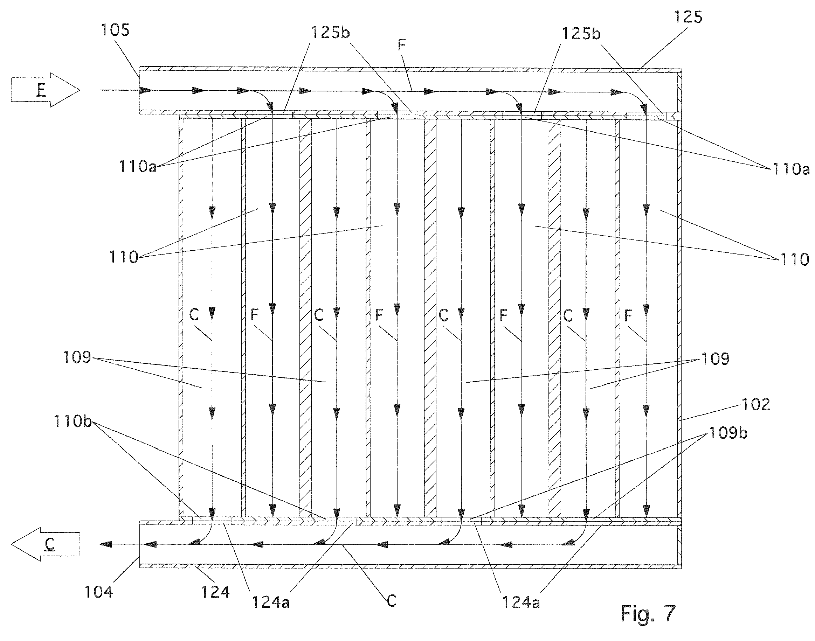

Along said path, which is well represented schematically also in Figures 6 and 7, the heat exchange fluids exchange heat with the opposing surfaces **120a, 120b** of the thermoelectric converters **120** that generate electric current. Also in this variant embodiment the first heat exchange fluid C comes into contact with the first surfaces **120a** of each one of the thermoelectric converters **120** and in this way produces a heat exchange through direct contact, whose exchange efficiency is thus certainly higher than the efficiency that can be obtained with the mentioned known generators, in which said heat exchange takes place by conduction through the interposed surfaces of the ducts in which said exchange fluid circulates.

Based on the above, it can thus be understood that the flow generator of the invention, in both of the embodiments described herein, achieves all the set objects.

First of all, the containment body, as shown in the figures, has box-shaped structures and can be obtained through simple and economic plate shearing, bending and assembling operations.

This makes the thermoelectric generator of the invention less expensive to construct than thermoelectric generators of the known art equivalent to it.

Furthermore, it has been pointed out that in the thermoelectric generator the thermoelectric converters are supported by laminar elements that are arranged parallel to one another so as to form, with the insulating panels facing them, a plurality of linear ducts for the flow of the heat exchange fluids.

This makes it possible to improve heat exchange with the cells and thus to obtain high power density, exceeding the power density that can be obtained from equivalent thermoelectric generators belonging to the known art.

In particular, it has been observed that the first heat exchange fluid C comes into contact with one of the surfaces of the thermoelectric converters, thus obtaining a heat exchange through direct contact, whose exchange efficiency is thus is certainly higher than the efficiency that can be obtained with the mentioned known generators, in which said heat exchange takes place by conduction through the interposed surfaces of the ducts in which said first heat exchange fluid circulates.

Consequently, the thermoelectric generator of the invention, with the same power yield, has reduced volume and thus reduced overall dimensions than equivalent thermoelectric generators of known type.

This also ensures more versatility in the use of the generator itself.

Furthermore, the simplicity of the construction form of the generator of the invention, which can be observed in particular in the drawings, facilitates any intervention in case of maintenance operations or repairs that may be necessary to replace any damaged thermoelectric converters that, on the other hand, in the thermoelectric generators of known type require a difficult replacing procedure.

Finally, the wafer-like structure of the generator, resulting from the arrangement of the thermoelectric converters on laminar elements and from the use of flat thermally insulating panels facing and spaced from the laminar elements, makes the thermoelectric generator of the invention modular, as its power can be easily increased by increasing the volume of the containment body and increasing the number of wafer elements and thus of laminar elements and of corresponding thermally insulating panels arranged inside it. Furthermore, to advantage, since each wafer element delimits an adiabatic chamber, there is an improvement in terms of thermal efficiency compared to equivalent known generators.

Based on the above, it can thus be understood that the thermoelectric generator that is the subject of the invention, in both of the embodiments described herein, achieves all the set objects.

Obviously, the embodiments of the generator that is the subject of the invention, and in particular the containment body, can be many and in any case different from those described herein.

Furthermore, in the construction stage the thermoelectric generator of the invention can be subjected to construction changes that are neither described herein not illustrated in the drawings.

It is understood that all the variants and modifications must be considered protected by the present patent, provided that they fall within the scope of the following claims.

Where technical features mentioned in any claim are followed by reference signs, those reference signs have been included for the sole purpose of increasing the intelligibility of the claims and accordingly such reference signs do not have any limiting effect on the protection of each element identified by way of example by such reference signs.

## Claims

1. Thermoelectric generator (1; 100) comprising:
- a containment body (2; 102) provided with walls (12a; 111) that delimit a heat exchange chamber (12; 112), in which it is possible to identify a first inlet way (3; 103) and a first outlet way (4; 104) of a first heat exchange fluid (C), as well as a second inlet way (5; 105) and a second outlet way (6; 106) of a second heat exchange fluid (F), said heat exchange fluids (C, F) having different temperatures;
- a plurality of thermoelectric converters (20; 120) arranged inside said containment body (2; 102), each one of which has a first surface (20a; 120a) facing towards said first heat exchange fluid (C) and a second surface (20b; 120b), opposite said first surface (20a; 120a), facing towards said second heat exchange fluid (F),
wherein said thermoelectric converters (20; 120) are supported by spaced laminar elements (7; 107) facing corresponding thermally insulating panels (8; 108), said laminar elements (7; 107) and said thermally insulating panels (8; 108) being housed inside said containment body (2; 102), where they define a plurality of first flow ducts (9; 109) communicating with said first inlet ways (3; 103) and outlet ways (4; 104) so as to ensure the circulation of said first heat exchange fluid (C) and a plurality of second flow ducts (10; 110) communicating with said second inlet ways (5; 105) and outlet ways (6; 106) so as to ensure the circulation of said second heat exchange fluid (F), each one of said first flow ducts (9; 109) being arranged so that it is adjacent and parallel to a corresponding second flow duct (10; 110) and each one of said thermoelectric converters (20; 120) having said first surface (20a; 120a) in direct contact with said first heat exchange fluid (C).

2. Thermoelectric generator (1; 100) according to claim 1, **characterized in that** said laminar elements (7; 107) and said thermally insulating panels (8; 108) are flat.

3. Thermoelectric generator (1; 100) according to claim 1 or 2, **characterized in that** each one of said second flow ducts (10; 110) is defined by one of said laminar elements (7; 107), by the corresponding thermally insulating panel (8; 108) facing it and by perimetric closing means (16, 12a; 111) that configure each one of said second flow ducts (10; 110) as an adiabatic chamber.

4. Thermoelectric generator (1) according to claim 3, **characterized in that** said adiabatic chamber is sealed through said perimetric closing means of each one of said flow ducts (10) comprising lateral closing edges (16) and said side walls (12a) delimiting said containment body (2).

5. Thermoelectric generator (1) according to any of the preceding claims, **characterized in that** said laminar elements (7) and said thermally insulating panels (8) are parallel to each other and to the flow direction of said first heat exchange fluid (C) defined by the longitudinal axis (X) according to which said first inlet ways (3) and outlet ways (4) of said containment body (2) are aligned.

6. Thermoelectric generator (100) according to any of the claims from 1 to 3, **characterized in that** said laminar elements (107) and said thermally insulating panels (108) are parallel to each other and orthogonal to the flow direction of said first heat exchange fluid (C) defined by the longitudinal axis (Yc) of said first inlet ways (103) and outlet ways (104) and of said containment body (102).

7. Thermoelectric generator (1) according to any of the claims from 1 to 5, **characterized in that** said containment body (2) comprises:
- a central section (11) that delimits said heat exchange chamber (12) and in which said laminar elements (7) and said thermally insulating panels (8) are arranged;
- an inlet section (13) whose profile diverges towards said central section (11), in which there is said first inlet way (3) of said first heat exchange fluid (C);
- an outlet section (14) whose profile diverges from said central section (11), in which there is said first outlet way (4) of said first heat exchange fluid (C).

8. Thermoelectric generator (100) according to any of the claims from 1 to 3 or 6, **characterized in that** said containment body (102) delimits a heat exchange chamber (112) in which said laminar elements (107) and said thermally insulating panels (108) are contained and comprises:
- a first inlet channel (123) provided with a first inlet way (103) of said first heat exchange fluid (C) and a plurality of first outlet mouths (123b), each one of which communicates with a corresponding first inlet mouth (109a) created in said containment body (102) and communicating with a respective first flow duct (109);
- a first outlet channel (124) provided with a first outlet way (104) of said first heat exchange fluid (C) and a plurality of first inlet mouths (124a), each one of which communicates with a corresponding first outlet mouth (109b) created in said containment body (102) and communicating with a respective first flow duct (109);
- a second inlet channel (125) provided with a second inlet way (105) of said second heat exchange fluid (F) and a plurality of second outlet mouths (125b), each one of which communicates with a corresponding second inlet mouth (110a) created in said containment body (102) and communicating with a respective second flow duct (110);
- a second outlet channel (126) provided with a second outlet way (106) of said second heat exchange fluid (F) and a plurality of second inlet mouths (126a), each one of which communicates with a corresponding second outlet mouth (110b) created in said containment body (102) and communicating with a respective second flow duct (110),
said laminar elements (107) and said thermally insulating panels (108) having their perimeter in contact with said walls (111) that delimit said heat exchange chamber (112) and make up said perimetric closing means of said flow ducts (109; 110).

9. Thermoelectric generator (100) according to claim 8, **characterized in that** each one of said inlet channels (123, 125) and outlet channels (124, 126) defines a longitudinal axis (Yc, Yf) that defines the flow direction of said heat exchange fluids (C, F) along said channels, said flow direction being orthogonal to said flow ducts (109, 110), to said laminar elements (107) and to said thermally insulating panels (108) that define said flow ducts (109, 110).

10. Thermoelectric generator (100) according to claim 9, **characterized in that** said inlet channels (123, 125) and outlet channels (124, 126) are tubular elements arranged outside said containment body (102) according to the configuration of a quadrilateral (Q) having each one of the corners (S) coinciding with the intersection point (P) of a corresponding longitudinal axis (Yc, Yf) of said channels (123, 125, 124, 126), said first inlet channels (123) and outlet channels (124) being arranged at the ends of a first diagonal (Qa) of said quadrilateral (Q) and said second inlet channels (125) and outlet channels (126) being arranged at the ends of a second diagonal (Qb) of the same quadrilateral (Q).

11. Thermoelectric generator (1) according to any of the claims from 1 to 5 or 7, **characterized in that** said second heat exchange fluid (F) that circulates in said second ducts (10) flows along a plurality of tubular coils (15) that are connected in series with one another and with said second inlet ways (5) and outlet ways (6), each one of said tubular coils (15) being housed in the corresponding second duct (10) where it is placed in contact with the laminar element (7) and with the thermally insulating panel (8) that delimit said second duct (10).

12. Thermoelectric generator (1) according to claim 11, **characterized in that** it comprises an auxiliary flat laminar element (7a) arranged inside said heat exchange chamber (12) in contact with the wall (12a) that delimits it and an auxiliary tubular coil (15a) arranged outside said heat exchange chamber (12) and in contact with said wall (12a) that delimits it, at the level of the area of said wall (12a) where, inside said heat exchange chamber (12), there is said auxiliary flat laminar element (7a).

## Patentansprüche

1. Wärmekraftaggregat (1; 100), Folgendes umfassend:
- einen Behälterkörper (2; 102) mit Wänden (12a; 111), die eine Wärmetauscherkammer (12; 112) begrenzen, in der ein erster Einlassweg (3; 103) und ein erster Auslassweg (4; 104) eines ersten Wärmetauscherfluids (C) identifiziert werden können, ebenso wie ein zweiter Einlassweg (5; 105) und ein zweiter Auslassweg (6; 106) eines zweiten Wärmetauscherfluids (F), wobei die besagten Wärmetauscherfluide (C, F) unterschiedliche Temperaturen aufweisen;
- eine Vielzahl thermoelektrischer Energiewandler (20; 120), die innerhalb des besagten Behälterkörpers (2; 102) angeordnet sind, von denen ein jeder eine erste Oberfläche (20a; 120a) aufweist, die zu dem besagten, ersten Wärmetauscherfluid (C) gerichtet ist, und eine zweite Oberfläche (20b; 120b), die der besagten ersten Oberfläche (20a; 120a) gegenüberliegt und zu dem besagten zweiten Wärmetauscherfluid (F) gerichtet ist,
**wobei** die besagten, thermoelektrischen Energiewandler (20; 120) durch voneinander distanzierte, blätterförmige Elemente (7; 107) gehalten werden, die zu entsprechenden, wärmeisolierenden Paneelen (8; 108) gerichtet sind, wobei die besagten, blätterförmigen Elemente (7; 107) und die besagten, wärmeisolierenden Paneele (8; 108) innerhalb des besagten Behälterkörpers (2; 102) enthalten sind, wo sie eine Vielzahl von ersten Flussleitungen (9; 109) definieren, die mit den besagten ersten Einlasswegen (3; 103) und Auslasswegen (4; 104) kommunizieren, um die Zirkulation des besagten, ersten Wärmetauscherfluids (C) zu gewährleisten, und eine Vielzahl von zweiten Flussleitungen (10; 110) definieren, die mit den besagten zweiten Einlasswegen (5; 105) und Auslasswegen (6; 106) kommunizieren, um die Zirkulation des besagten zweiten Wärmetauscherfluids (F) zu gewährleisten, wobei jede der besagten Flussleitungen (9; 109) so angeordnet ist, dass sie neben und parallel zu einer entsprechenden, zweiten Flussleitung (10; 110) liegt und die besagte erste Oberfläche (20a; 120a) jedes der besagten, thermoelektrischen Energiewandler (20; 120) in direktem Kontakt mit dem besagten ersten Wärmetauscherfluid (C) steht.

2. Wärmekraftaggregat (1; 100) gemäß Patentanspruch 1, **dadurch gekennzeichnet, dass** die besagten, blätterförmigen Elemente (7; 107) und die besagten, wärmeisolierenden Paneele (8; 108) flach sind.

3. Wärmekraftaggregat (1; 100) gemäß Patentanspruch 1 oder 2, **dadurch gekennzeichnet, dass** jede der besagten, zweiten Flussleitungen (10; 110) durch eines der besagten, blätterförmigen Elemente (7; 107) definiert ist, sowie durch das entsprechende, zu diesem gerichtete wärmeisolierende Paneel (8; 108), und durch rundum begrenzende Verschlussmittel (16, 12a; 111), die jede der besagten zweiten Flussleitungen (10; 110) als eine adiabatische Kammer konfigurieren.

4. Wärmekraftaggregat (1) gemäß Patentanspruch 3, **dadurch gekennzeichnet, dass** die besagte adiabatische Kammer durch die besagten, rundum begrenzenden Verschlussmittel jeder der besagten Flussleitungen (10), welche seitliche Verschlusskanten (16) umfassen, und durch die besagten Seitenwände (12a), die den besagten Behälterkörper (2) begrenzen, dicht versiegelt ist.

5. Wärmekraftaggregat (1) gemäß eines jeden der vorstehenden Patentansprüche, **dadurch gekennzeichnet, dass** die besagten, blätterförmigen Elemente (7) und die besagten, wärmeisolierenden Paneele (8) parallel zueinander und zur Flussrichtung des besagten ersten Wärmetauscherfluids (C) liegen, die durch die Längsachse (X) definiert ist, entlang welcher die besagten ersten Einlasswege (3) und Auslasswege (4) des besagten Behälterkörpers (2) ausgerichtet sind.

6. Wärmekraftaggregat (100) gemäß eines jeden der Patentansprüche von 1 bis 3, **dadurch gekennzeichnet, dass** die besagten, blätterförmigen Elemente (107) und die besagten, wärmeisolierenden Paneele (108) parallel zueinander und orthogonal zur Flussrichtung des besagten ersten Wärmetauscherfluids (C) liegen, die durch die Längsachse (Yc) der besagten ersten Einlasswege (103) und Auslasswege (104) und des besagten Behälterkörpers (102) definiert ist.

7. Wärmekraftaggregat (1) gemäß eines jeden der Patentansprüche von 1 bis 5, **dadurch gekennzeichnet, dass** der besagte Behälterkörper (2) Folgendes umfasst:
- einen mittleren Bereich (11), der die besagte Wärmetauscherkammer (12) begrenzt, und in dem die besagten, blätterförmigen Elemente (7) und die besagten, wärmeisolierenden Paneele (8) angeordnet sind;
- einen Einlassbereich (13), dessen Profil zu dem besagten, mittleren Bereich (11) divergiert, in dem sich der besagte erste Einlassweg (3) des besagten ersten Wärmetauscherfluids (C) befindet;
- einen Auslassbereich (14), dessen Profil von dem besagten, mittleren Bereich (11) divergiert, in dem sich der besagte erste Auslassweg (4) des besagten ersten Wärmetauscherfluids (C) befindet.

8. Wärmekraftaggregat (100) gemäß eines jeden der Patentansprüche von 1 bis 3 oder 6, **dadurch gekennzeichnet, dass** der besagte Behälterkörper (102) eine Wärmetauscherkammer (112) begrenzt, in welcher die besagten blätterförmigen Elemente (107) und die besagten wärmeisolierenden Paneele (108) enthalten sind, und Folgendes umfasst:
- einen ersten Einlasskanal (123) mit einem ersten Einlassweg (103) des besagten, ersten Wärmetauscherfluids (C) und einer Vielzahl von ersten Auslassöffnungen (123b), von denen jede mit einer entsprechenden, ersten Einlassöffnung (109a) kommuniziert, die in dem besagten Behälterkörper (102) ausgeführt ist und mit einer entsprechenden, ersten Flussleitung (109) kommuniziert;
- einen ersten Auslasskanal (124) mit einem ersten Auslassweg (104) des besagten, ersten Wärmetauscherfluids (C) und einer Vielzahl von ersten Einlassöffnungen (124a), von denen jede mit einer entsprechenden, ersten Auslassöffnung (109b) kommuniziert, die in dem besagten Behälterkörper (102) ausgeführt ist und mit einer entsprechenden, ersten Flussleitung (109) kommuniziert;
- einen zweiten Einlasskanal (125) mit einem zweiten Einlassweg (105) des besagten, zweiten Wärmetauscherfluids (F) und einer Vielzahl von zweiten Auslassöffnungen (125b), von denen jede mit einer entsprechenden, zweiten Einlassöffnung (110a) kommuniziert, die in dem besagten Behälterkörper (102) ausgeführt ist und mit einer entsprechenden, zweiten Flussleitung (110) kommuniziert;
- einen zweiten Auslasskanal (126) mit einem zweiten Auslassweg (106) des besagten, zweiten Wärmetauscherfluids (F) und einer Vielzahl von zweiten Einlassöffnungen (126a), von denen jede mit einer entsprechenden, zweiten Auslassöffnung (110b) kommuniziert, die in dem besagten Behälterkörper (102) ausgeführt ist und mit einer entsprechenden, zweiten Flussleitung (110) kommuniziert,
wobei der Umfang der besagten, blätterförmigen Elemente (107) und der besagten, wärmeisolierenden Paneele (108) in Kontakt mit den besagten Wänden (111) steht, welche die besagte Wärmetauscherkammer (112) begrenzen, und die besagten, rundum begrenzenden Verschlussmittel der besagten Flussleitungen (109; 110) bilden.

9. Wärmekraftaggregat (100) gemäß Patentanspruch 8, **dadurch gekennzeichnet, dass** jeder der besagten Einlasskanäle (123, 125) und Auslasskanäle (124, 126) eine Längsachse (Yc, Yf) definiert, welche die Flussrichtung der besagten Wärmetauscherfluide (C, F) entlang der besagten Kanäle definiert, wobei die besagte Flussrichtung orthogonal zu den besagten Flussleitungen (109, 110), zu den besagten, blätterförmigen Elementen (107) und zu den besagten, die besagten Flussleitungen (109, 110) definierenden wärmeisolierenden Paneelen (108) steht.

10. Wärmekraftaggregat (100) gemäß Patentanspruch 9, **dadurch gekennzeichnet, dass** die besagten Einlasskanäle (123, 125) und Auslasskanäle (124, 126) röhrenförmige Elemente sind, die außerhalb des besagten Behälterkörpers (102) angeordnet sind gemäß der Konfiguration eines Vierseits (Q), dessen Ecken (S) alle mit dem Schnittpunkt (P) einer entsprechenden Längsachse (Yc, Yf) der besagten Kanäle (123, 125, 124, 126) zusammenfallen, wobei die besagten ersten Einlasskanäle (123) und Auslasskanäle (124) an den Enden einer ersten Diagonale (Qa) des besagten Vierseits (Q) angeordnet sind und die besagten zweiten Einlasskanäle (125) und Auslasskanäle (126) an den Enden einer zweiten Diagonale (Qb) desselben Vierseits (Q) angeordnet sind.

11. Wärmekraftaggregat (1) gemäß eines jeden der Patentansprüche von 1 bis 5 oder 7, **dadurch gekennzeichnet, dass** das besagte zweite, in den besagten zweiten Leitungen (10) zirkulierende Wärmetauscherfluid (F) entlang einer Vielzahl röhrenförmiger Rohrschlangen (15) fließt, die in Reihe miteinander sowie mit den besagten zweiten Einlasswegen (5) und Auslasswegen (6) verbunden sind, wobei jede der besagten, röhrenförmigen Rohrschlangen (15) in der entsprechenden zweiten Leitung (10) positioniert ist, wo sie in Kontakt mit dem blätterförmigen Element (7) und mit dem wärmeisolierenden Paneel (8) steht, die die besagte zweite Leitung (10) begrenzen.

12. Wärmekraftaggregat (1) gemäß Patentanspruch 11, **dadurch gekennzeichnet, dass** es ein zusätzliches flaches, blätterförmiges Element (7a) umfasst, das innerhalb der besagten Wärmetauscherkammer (12) in Kontakt mit der Wand (12a) angeordnet ist, die sie begrenzt, und eine zusätzliche, röhrenförmige Rohrschlange (15a), die außerhalb der besagten Wärmetauscherkammer (12) und in Kontakt mit der besagten Wand (12a), die sie begrenzt, angeordnet ist, auf der Höhe des Bereichs der besagten Wand (12a), in dem sich innerhalb der besagten Wärmetauscherkammer (12) das besagte zusätzliche, flache, blätterförmige Element (7a) befindet.

## Revendications

1. Générateur thermoélectrique (1; 100) comprenant:
- un corps de confinement (2; 102) doté de parois (12a; 111) qui délimitent une chambre d'échange thermique (12; 112), dans lequel il est possible d'identifier une première voie d'entrée (3; 103) et une première voie de sortie (4; 104) d'un premier fluide d'échange thermique (C), ainsi qu'une deuxième voie d'entrée (5; 105) et une deuxième voie de sortie (6; 106) d'une deuxième fluide d'échange thermique (F), lesdits fluides d'échange thermique (C, F) ayant des températures différentes;
- une pluralité de convertisseurs thermoélectriques (20; 120) disposés à l'intérieur dudit corps de confinement (2; 102), chacun desquels présente une première surface (20a; 120a) tournée vers ledit premier fluide d'échange thermique (C) et une deuxième surface (20b; 120b), opposée à ladite première surface (20a; 120a), tournée vers ledit deuxième fluide d'échange thermique (F),
**où** lesdits convertisseurs thermoélectriques (20; 120) sont supportés par des éléments laminaires espacés (7; 107) tournés vers des panneaux thermiquement isolants correspondants (8; 108), lesdits éléments laminaires (7; 107) et lesdits panneaux thermiquement isolants (8; 108) étant logés à l'intérieur dudit corps de confinement (2; 102), où ils définissent une pluralité de premiers conduits d'écoulement (9; 109) communiquant avec lesdites premières voies d'entrée (3; 103) et de sortie (4; 104) de façon à garantir la circulation dudit premier fluide d'échange thermique (C), et une pluralité de deuxièmes conduits d'écoulement (10; 110) communiquant avec lesdites deuxièmes voies d'entrée (5; 105) et de sortie (6; 106) de façon à garantir la circulation dudit deuxième fluide d'échange thermique (F), chacun desdits premiers conduits d'écoulement (9; 109) étant disposé adjacent et parallèle à un deuxième conduit d'écoulement correspondant (10; 110) et chacun desdits convertisseurs thermoélectriques (20; 120) présentant ladite première surface (20a; 120a) en contact direct avec ledit premier fluide d'échange thermique (C).

2. Générateur thermoélectrique (1; 100) selon la revendication 1, **caractérisé en ce que** lesdits éléments laminaires (7; 107) et lesdits panneaux thermiquement isolants (8; 108) sont plats.

3. Générateur thermoélectrique (1; 100) selon la revendication 1 ou 2, **caractérisé en ce que** chacun desdits deuxièmes conduits d'écoulement (10; 110) est défini par un desdits éléments laminaires (7; 107), par le panneau thermiquement isolant correspondant (8; 108) tourné vers celui-ci et par des moyens périmétriques de fermeture (16, 12a; 111) qui configurent chacun desdits deuxièmes conduits d'écoulement (10; 110) comme une chambre adiabatique.

4. Générateur thermoélectrique (1) selon la revendication 3, **caractérisé en ce que** ladite chambre adiabatique est fermée hermétiquement par lesdits moyens périmétriques de fermeture de chacun desdits conduits d'écoulement (10) qui comprennent des bords latéraux de fermeture (16) et lesdites parois latérales (12a) qui délimitent ledit corps de confinement (2).

5. Générateur thermoélectrique (1) selon l'une quelconque des revendications précédentes, **caractérisé en ce que** lesdits éléments laminaires (7) et lesdits panneaux thermiquement isolants (8) sont parallèles entre eux et à la direction d'écoulement dudit premier fluide d'échange thermique (C) définie par l'axe longitudinal (X) selon lequel lesdites premières voies d'entrée (3) et de sortie (4) dudit corps de confinement (2) sont alignées.

6. Générateur thermoélectrique (100) selon l'une quelconque des revendications de 1 à 3, **caractérisé en ce que** lesdits éléments laminaires (107) et lesdits panneaux thermiquement isolants (108) sont parallèles entre eux et orthogonaux à la direction d'écoulement dudit premier fluide d'échange thermique (C) définie par l'axe longitudinal (Yc) desdites premières voies d'entrée (103) et de sortie (104) et dudit corps de confinement (102).

7. Générateur thermoélectrique (1) selon l'une quelconque des revendications de 1 à 5, **caractérisé en ce que** ledit corps de confinement (2) comprend:
- une section centrale (11) qui délimite ladite chambre d'échange thermique (12) et dans laquelle se trouvent lesdits éléments laminaires (7) et lesdits panneaux thermiquement isolants (8);
- une section d'entrée (13) ayant un profil divergeant vers ladite section centrale (11), dans laquelle se trouve ladite première voie d'entrée (3) dudit premier fluide d'échange thermique (C);
- une section de sortie (14) ayant un profil divergeant de ladite section centrale (11), dans laquelle se trouve ladite première voie de sortie (4) dudit premier fluide d'échange thermique (C).

8. Générateur thermoélectrique (100) selon l'une quelconque des revendications de 1 à 3 ou 6, **caractérisé en ce que** ledit corps de confinement (102) délimite une chambre d'échange thermique (112) dans laquelle lesdits éléments laminaires (107) et lesdits panneaux thermiquement isolants (108) sont contenus et comprend:
- un premier canal d'entrée (123) doté d'une première voie d'entrée (103) dudit premier fluide d'échange thermique (C) et d'une pluralité de premières bouches de sortie (123b), chacune desquelles communique avec une première bouche d'entrée correspondante (109a) réalisée dans ledit corps de confinement (102) et communiquant avec un premier conduit d'écoulement correspondant (109);
- un premier canal de sortie (124) doté d'une première voie de sortie (104) dudit premier fluide d'échange thermique (C) et d'une pluralité de premières bouches d'entrée (124a), chacune desquelles communique avec une première bouche de sortie correspondante (109b) réalisée dans ledit corps de confinement (102) et communiquant avec un premier conduit d'écoulement correspondant (109);
- un deuxième canal d'entrée (125) doté d'une deuxième voie d'entrée (105) dudit deuxième fluide d'échange thermique (F) et d'une pluralité de deuxièmes bouches de sortie (125b), chacune desquelles communique avec une deuxième bouche d'entrée correspondante (110a) réalisée dans ledit corps de confinement (102) et communiquant avec un deuxième conduit d'écoulement correspondant (110);
- un deuxième canal de sortie (126) doté d'une deuxième voie de sortie (106) dudit deuxième fluide d'échange thermique (F) et d'une pluralité de deuxièmes bouches d'entrée (126a), chacune desquelles communique avec une deuxième bouche de sortie correspondante (110b) réalisée dans ledit corps de confinement (102) et communiquant avec un deuxième conduit d'écoulement correspondant (110),
lesdits éléments laminaires (107) et lesdits panneaux thermiquement isolants (108) présentant leur périmètre en contact avec lesdites parois (111) qui délimitent ladite chambre d'échange thermique (112) et qui constituent lesdits moyens périmétriques de fermeture desdits conduits d'écoulement (109; 110).

9. Générateur thermoélectrique (100) selon la revendication 8, **caractérisé en ce que** chacun desdits canaux d'entrée (123, 125) et de sortie (124, 126) définit un axe longitudinal (Yc, Yf) qui définit la direction d'écoulement desdits fluides d'échange thermique (C, F) le long desdits canaux, ladite direction d'écoulement étant orthogonale auxdits conduits d'écoulement (109, 110), auxdits éléments laminaires (107) et auxdits panneaux thermiquement isolants (108) qui définissent lesdits conduits d'écoulement (109, 110).

10. Générateur thermoélectrique (100) selon la revendication 9, **caractérisé en ce que** lesdits canaux d'entrée (123, 125) et de sortie (124, 126) sont des éléments tubulaires disposés extérieurement audit corps de confinement (102) selon la configuration d'un quadrilatère (Q) ayant chacun des angles (S) coïncidant avec le point de croisement (P) d'un axe longitudinal correspondant (Yc, Yf) desdits canaux (123, 125, 124, 126), lesdits premiers canaux d'entrée (123) et de sortie (124) étant disposés aux extrémités d'une première diagonale (Qa) dudit quadrilatère (Q) et lesdits deuxièmes canaux d'entrée (125) et de sortie (126) étant disposés aux extrémités d'une deuxième diagonale (Qb) du même quadrilatère (Q).

11. Générateur thermoélectrique (1) selon l'une quelconque des revendications de 1 à 5 ou 7, **caractérisé en ce que** ledit fluide d'échange thermique (F) qui circule dans lesdits deuxièmes conduits (10) s'écoule le long d'une pluralité de serpentins tubulaires (15) qui sont reliés en série entre eux et avec lesdites deuxièmes voies d'entrée (5) et de sortie (6), chacun desdits serpentins tubulaires (15) étant logé dans le deuxième conduit correspondant (10) où il est en contact avec l'élément laminaire (7) et avec le panneau thermiquement isolant (8) qui délimitent ledit deuxième conduit (10).

12. Générateur thermoélectrique (1) selon la revendication 11, **caractérisé en ce qu**'il comprend un élément laminaire plat auxiliaire (7a) disposé à l'intérieur de ladite chambre d'échange thermique (12) en contact avec la paroi (12a) qui la délimite et un serpentin tubulaire auxiliaire (15a) disposé à l'extérieur de ladite chambre d'échange thermique (12) et en contact avec ladite paroi (12a) qui la délimite, à hauteur de la zone de ladite paroi (12a) où, à l'intérieur de ladite chambre d'échange thermique (12), ledit élément laminaire plat auxiliaire (7a) est disposé.
